Europäisches Patentamt

European Patent Office

Office européen des brevets

(11) Publication number : **0 466 457 A1**

# (12) EUROPEAN PATENT APPLICATION

(21) Application number : 91306220.4

(51) Int. Cl.⁵ : **C30B 15/30**

(22) Date of filing : 09.07.91

(30) Priority : **13.07.90 JP 185659/90**

(43) Date of publication of application :
**15.01.92 Bulletin 92/03**

(84) Designated Contracting States :
**DE FR GB**

(71) Applicant : **SHIN-ETSU HANDOTAI COMPANY, LIMITED**
**4-2, Marunouchi 1-Chome**
**Chiyoda-ku Tokyo (JP)**

(72) Inventor : **Fusegawa, Izumi**
**Yanase 791-4**
**Annaka-shi, Gunma-ken (JP)**
Inventor : **Yamagishi, Hirotoshi**
**Annaka 1721-3**
**Annaka-shi, Gunma-ken (JP)**

(74) Representative : **Pacitti, Pierpaolo A.M.E. et al**
**Murgitroyd and Company Mitchell House 333**
**Bath Street**
**Glasgow G2 4ER Scotland (GB)**

(54) Method for pulling semiconductor single crystal.

(57)   In the production of a semiconductor single crystal from a molten mass of the material for the semiconductor crystal held in a container by the magnetic field-applied method, the otherwise inevitable occurrence of growth striations in the produced single crystal can be precluded by fixing the rotational speed of the container at a level in the range of from 0.2 to 5 rpm and the intensity of the magnetic field applied to the molten mass at a level in the range of from 2,000 to 5,000gausses.

EP 0 466 457 A1

BACKGROUND OF THE INVENTION

FIELD OF THE INVENTION

This invention relates to a method for pulling a semiconductor single crystal while abating the occurrence of growth striations in the produced single crystal.

DESCRIPTION OF THE PRIOR ART

It has been heretofore well known that in the growth of a semiconductor single crystal by the Czochralski Method (CZ method), since the semiconductor crystal already grown is partially remelted or the semiconductor crystal in process of growth is compelled to incorporate irregularly therein the oxygen liberated by melting from the crucible because of the thermal convection, vibration, etc. of the molten mass of the material for the semiconductor crystal, the produced semiconductor single crystal sustains a crystal defect or growth striations.

For enabling the crystal to be pulled while abating such uncalled-for motions as thermal convection and vibration in the molten mass, therefore, the magnetic field-applied Czochralski method (MCZ method) has been proposed. An experiment demonstrating this method to be effective in curbing the occurrence of growth striations in the produced crystal has been reported (K. Hoshi, T. Suzuki, Y. Okubo, and N. Isawa: Extended Abstracts of Electrochem., 1980, p. 811).

In the pull of a single crystal by the MCZ method mentioned above, there is an established practice of adopting a procedure which comprises continuing the pull of the single crystal while keeping the crucible in rotation so as to make up for possible deviation of the center of heat generated by heating means disposed around the crucible thereby ensuring the production of a single crystal possessing a perfectly circular cross section. The rotation of the crucible gives rise to an undulation of temperature and consequently induces the occurrence of growth striations due to the rotation of the crucible in the single crystal grown by the pull. Such conventional MCZ method, therefore, is not a perfect solution for prevention of the occurrence of growth striations.

As means for growing a crystal possessing a perfectly circular cross section and containing no growth striation by correcting the possible deviation of the center of heat while rotating the crucible, Japanese Patent Publication No. Sho 61-21,195 discloses a method which comprises heating a molten mass or solution of the material for crystal kept in a container with a heating member (divided heater) disposed along the periphery of the container as divided in a vertical direction of the container and adapted to be independently regulated to uniformize the temperature distribution of the molten mass or solution in the horizontal direction and pulling a single crystal from the molten mass or solution under application of a magetic field.

When the divided heater designed as described above are used for the purpose of uniformizing the temperature distribution in the horizontal direction, however, the control of this divided heater is still extremely difficult and the balance of heat in the horizontal direction is not attained and the crystal attains only abnormal growth and fails to acquire a perfectly circular cross section. Further, owing to the inevitable undulation of temperature resulting from poor control of heating, the use of the divided heater induces anew the occurrence of growth strtiations.

SUMMARY OF THE INVENTION

This invention aims to solve the problem mentioned above and has as an object thereof the provision of a method for pulling a semiconductor single crystal and producing a semiconductor single crystal of perfectly circular cross section in a state having the occurrence of growth striations abated to the fullest possible extent.

To be specific, this invention is directed to a magnetic field-applied method for pulling a semiconductor crystal from the molten mass of a material for the semiconductor crystal kept in a container, which method is characterized by keeping the rotational speed of the container in the range of from 0.2 to 5 rpm and the intensity of the magnetic field applied to the molten mass in the range of from 2,000 to 5,000 gausses.

BRIEF DESCRIPTION OF THE DRAWINGS

This and other objects and features of the present invention will become apparent from the follwoing description of preferred embodiments thereof taken in conjunction with the accompanying drawings, in which:

Fig. 1 is a partial cross section schematically illustrating the construction of an apparatus to be used in executing the method of this invention.

Fig. 2 is an explanatory diagram drawn by sketching the result of observation under an optical microscope of a growth striation in a crystal obtained in Example 1.

Fig. 3 is an explanatory diagram drawn by sketching the result of observation under an optical microscope of a growth striation in a crystal obtained in Comparative Experiment 1.

Fig. 4 is an explanatory diagram drawn by sketching the result of observation under an optical microscope of a growth striation in crystal obtained in Comparative Experiment 2.

DETAILED DESCRIPTION OF THE INVENTION

In the present invention, the container accommodating the molten mass of the material for the semiconductor crystal is rotated at a speed in the range of from 0.2 to 5 rpm. If the container is rotated at speed exceeding 5 rpm, the molten mass generates forced flow and vibration and the crystal already grown is partially remelted and possibly compelled to sustain growth striations and crystal defects and the concentration of the oxygen dissolving out of the crucible and mingling into the molten mass owing to the friction between the inner wall surface of crucible and the molten mass is heightened. Conversely, if the crucible is not rotated at all, the heat distribution in the molten mass shows poor symmetry and the crystal attains abnormal growth and the produced semiconductor single crystal fails to acquire a completely circular cross section. Thus, the rotational speed of the crucible is required to exceed 0.2 rpm at least.

Further in this invention, a magnetic field of an intensity in the range of from 2,000 to 5,000 gausses is applied to the molten mass. If this intensity of the magnetic field is less than 2,000 gausses, it is no longer possible to heighten the effective viscosity of the molten mass or to abate the heat convection and the forced flow generated by the rotation of the crucible.

When the magnetic field applied to the molten mass perpendicularly to the direction of flow of the heat convection, it is conspicuously effective in abating the heat convection. In this sense, use of a horizontal magnetic field proves to be particularly desirable.

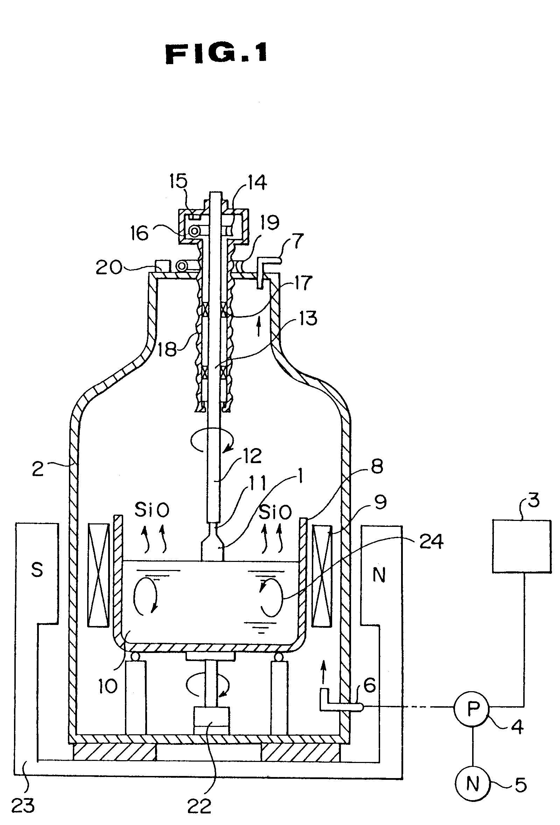

Now, this invention will be described more particularly below with reference to the accompanying drawings. Fig. 1 is a longitudinal cross section schematically illustrating a typical apparatus for pulling a single crystal of silicon in accordance with the method of this invention.

In Fig. 1, 8 stands for crucible. The crucible 8 is disposed at the center of the interior of a hermetically sealed furnace 2, opened in the upper side, and formed of quartz (SiO$_2$). The crucible 8 accommodates therein silicon. Heating means 9 is laid to encircle the crucible 8 and apply heat to the silicon in the crucible and transform it into a molten mass. Since the melting point of silicon is about 1,420 °C , the heating means 9 requires to possess a heating electric power capable of heating silicon to at least the heating point mentioned above.

A seed crystal 11 formed of a single crystal of silicon is disposed in contact with the surface of a molten mass 10 of silicon. The seed crystal 11 is connected to a rotary shaft 13 through the medium of pulling chuck 12. The rotary shaft 13 has a worm gear 14 fixed thereon and is rotated by pinion gear 16 connected to a motor 15. The rotation gives rise to a diffusion layer in the the molten mass on the surface of the seed crystal in contact therewith. The rotary shaft 13 is supported as engaged with a pulling device 18 through the medium of a bearing 17, for example. A fine thread is formed on the periphery of the pulling device 18. The fine thread is meshed with the worm screw 19 which is rotated by a motor 20 and pinion gear 21. Owing to the constructiondescribed above, the seed crystal 11 is rotated by the motor 15 and, at the same time, pulled up or down in the axial direction of the rotary shaft in consequence of the motion of the pulling device 18 in the axialdirection (vertical direction) thereof by the motor 20.

The crucible 8 is rotatably supported on the bottom surface of the hermetically sealed furnace 2 and is rotated by a motor 22 which is mounted on the bottom surface.

Magnetic field-generating means 23 formed such as of an electromagnet capable of generating a direct current magnetic field is disposed to encircle the hermetically sealed furnace 2. This magnetic field-generating means is so disposed asto form a horizontal magnetic field perpendicular to the direction of the axis of rotation of the seed crystal 11.

The oxygen of the crucible 8 dissolves out of the crucible and mingles into the molten mass 10 kept inside the crucible 8. Part of the oxygen in the molten mass vaporizes in the form of SiO from the surface of the molten mass 10 into the interior of the hermetically sealed furnace 12.

The hermetically sealed furnace 2 is so adapted as to permit supply of argon gas to the interior thereof. The argon gas from an argon gas source 3 is supplied via a supply inlet 6 into the interior of the hermetically sealed furnace 2 by a pump 4 which is driven by a motor 5. Inside the furnace 2, the argon gas is accompanied by the SiO gas filling the hermetically sealed furnace 2 and is discharged through an outlet 7.

Preparatorily to the pull of a-single crystal rod 1 of silicon, the argon gas is passed through the interior of the hermetically sealed furnace 2 and, at the same time, the horizontal magnetic field is formed around the crucible 8. Simultaneously, the silicon inside the crucible 8 is heated by the heating means 9 and consequently transformed into the molten mass 10 of a proper temperature. Then, the crucible 8 is set rotating at a prescribed speed in the range of from 0.2 to 5 rpm. Subsequently, the seed crystal 11 is rotated in the direction opposite that of the rotation of the crucible and, at the same time, moved at low speed in the pulling direction. In consequence of the operation described above, the formation of the single crystal rod 1 of silicon is effected. Though the pulling speed of the seed crystal 11 is not specifically defined in numerical value, a slow pulling speed of not more than about 7.5 cm/hour, for example, is adopted.

In the magnetic field-applied method, the occurrence of forced flow and vibration in the molten mass is abated and the partial remelting of the already grown crystal is prevented by setting the rotational speed of the container accommodating the material for the semiconductor crystal at such a low level as in the range of from 0.2 to 5 rpm. The abatement of the forced flow and vibration mentioned above is accomplished more effectively by the application to the the molten mass of the magnetic field of an intensity in the range of from 2,000 to 5,000 gausses. Thus, the occurrence of growth striations and crystal defects is curbed.

Further, since the container is rotated at a speed in the range of from 0.2 to 5 rpm, the heat distribtion in the molten mass shows satisfactory symmetry and the crystal avoids abnormal growth and the produced semiconductor single crystal attains a perfectly circular cross section.

Since the occurrence of heat convection, forced flow, and vibration is abated by the application of an intense magnetic field of 2,000 to 5,000 gausses and, moreover, the container is rotated at such a low speed as falling in the range of from 0.2 to 5 rpm, the otherwise possible adulteration of the molten mass with the component element of the container dissolved by the friction between the molten mass and the inner wall surface of the container can be precluded. In case where the material for the semiconductor crystal is silicon and the container is a quartz crucible, for example, the concentration of the oxygen to be introduced into the single crystal of silicon can be decreased to a very low level.

Now, the present invention will be described more specifically below with reference to working examples.

Example 1:

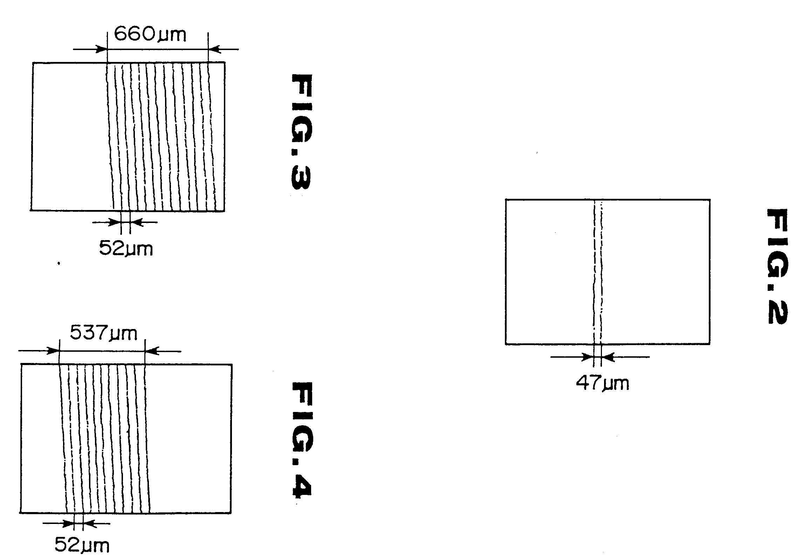

A quartz crucible 450 mm in diameter was charged with 60 kg of silicon and operated to grow a p type ($\sim$20 $\Omega$ .cm) crystal 150 mm in diameter. The growth of a single crystal was carried out, with a magnetic field applied in the horizontal direction at a fixed intensity of 3,000 gausses, the crystal rotated at a fixed speed of 20 rpm, and the quartz crucible rotated in direction opposite that of the crystal at four different speeds of 0.5, 1.0, 2.0, and 4.0 rpm. The produced semiconductor single crystal were evaluated with respect to growth striations by a procedure which comprised longitudinally splitting a given crystal, etching the test piece consequently obtained in an aqueousHF solution containing dissolved $NaNo_3$ while keeping it exposed to a visible light, and thereafter examining the etched surface of the test piece under an optical microscope to detect growth striations. The result of an experiment involving a quartz crucible rotation speed of 0.5 rpm is illustrated as an example in Fig. 2.

Comparative Experiment 1:

A crystal was grown by following the procedure of Example 1, excepting the application of a magnetic field was omitted and the rotational speed of the crucible was fixed at 0.5 rpm. The produced crystal was evaluated in the same manner as in Example 1. The result is shown Fig. 3.

Comarative Experiment 2:

A crystal was grown by following the procedure of Example 1, excepting the intensity of the applied magnetic field was fixed at 3,000 gausses and the rotational speed of the crucible was changed to 8 rpm. The produced crystal was evaluated in the same manner as in Example 1. The resutls is shown in Fig. 4.

It is noted from Fig. 3 that the crystal grown in the absence of a magnetic field (Comparative Experiment 1), after being etched, showed growth striations spaced regularly with an interval of about 50 $\mu$m and growth striations spaced irregularly at a large interval (about 500 $\mu$m). The crystal produced in an experiment with the crucible rotated at 0.5 rpm and the magnetic field appliedat an intensity of 3,000 gausses (Example 1) only showed growth striations spaced regularly at a small interval as illustrated in Fig. 2. The crystal produced in an experiment with the crucible rotated at 8 rpm and the magnetic field applied at an intensity of 3,000 gausses (Comparative Experiment 2), similarly to the crystal grown in the absence of a magnetic field, showed growth striations spaced irregularly at a large interval and growth striations spaced regularly with a small interval as illustrated in Fig. 3.

From the results described above, it is inferred that the flows such as heat convection cannot be curbed and the occurrence of growth striations cannot be precluded in the absence of a magnetic field even when the crucible is rotated at a low speed (Comparative Experiment 1). It is further noted that even when the intensity of the magnetic field to be applied is as high as 3,000 gausses, the flows generated by the rotation of the crucible cannot be abated if the rotational speed of the crucible is unduly large. In contrast, it is noted that when the crucible is rotated at a low speed and the magnetic field is applied at a high intensity (Example 1), the forced current arising from such factors as heat convection, vibration, and rotation of the crucible can be abated and the occurrence of growth striations caused by such factors can be precluded.

From the description given above, it is clear that this invention permits a semiconductor single crystal of a perfectly circular cross section to be obtained in the state having the occurrence of growth striations curbed to the fullest possible extent. Further, the adulteration of the single crystal with the component elements of the container occurs only sparingly. In case where the material of the semiconductor crystal is silicon and the container is a quartz crucible, for example, the produced single crystal of silicon has a low oxygen concentration.

## Claims

1. A magnetic field-applied method for pulling a semiconductor crystal from the molten mass of a material for said semiconductor crystal kept in a container, which method is characterized by keeping the rotational speed of said container in the range of from 0.2 to 5 rpm and the intensity of the magnetic field applied to said molten mass in the range of from 2,000 to 5,000 gausses.

# FIG.1

# FIG.2

# FIG.3

# FIG.4

EP 0 466 457 A1

**European Patent Office**

# EUROPEAN SEARCH REPORT

Application Number

EP 91 30 6220

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | JOURNAL OF CRYSTAL GROWTH, vol. 97, no. 1, September 1989, pages 85-91, Amsterdam, NL; R.W. SERIES: "Czochralski growth of silicon under an axial magnetic field" * Table 1; page 85 * | 1 | C 30 B 15/30 |
| X | SOLID STATE TECHNOLOGY, vol. 33, no. 4, April 1990, pages 163-167, Tulsa, OK, US; R.N. THOMAS et al.: "Melt growth of large diameter semiconductors: Part II" * Page 164; figures 12,13 * | 1 | |
| X | JOURNAL OF THE ELECTROCHEMICAL SOCIETY, vol. 132, no. 3, March 1985, pages 693-700, Manchester, NH, US; K. HOSHI et al.: "Czochralski silicon crystals grown in a transverse magnetic field" * Page 694, column 1, lines 1-10 * | 1 | |
| A | EP-A-0 194 051 (K.K. TOSHIBA) | | TECHNICAL FIELDS SEARCHED (Int. Cl.5) |
| A | EP-A-0 135 676 (IBM CORP.) | | C 30 B |

The present search report has been drawn up for all claims

| Place of search | Date of completion of the search | Examiner |
|---|---|---|
| THE HAGUE | 08-10-1991 | COOK S.D. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)